# EUROPEAN PATENT APPLICATION

(11) **EP 2 871 669 A1**
(43) Date of publication of application: **13.05.2015**
(21) Application number: 13192013.4
(22) Date of filing: 07.11.2013
(51) Int. Cl.: H01L 21/3065, C23C 16/44, F17C 1/00, H01L 21/3213

(54) **Gas mixture and gas transportation vessel therefor**

(71) Applicant: Solvay SA, 1120 Bruxelles (BE)
(72) Inventor: The designation of the inventor has not yet been filed
(74) Representative: Mross, Stefan P.M.

(57) **Abstract**

The present invention provides a transportable gas mixture comprising molecular fluorine and nitrous oxide and optionally argon and/or nitrogen as well as a gas transportation vessel containing said gas mixture.

## Description

The present invention concerns a transportable gas mixture comprising fluorine and nitrous oxide as well as a gas transportation vessel for the supply of said gas mixtures and a semiconductor manufacturing plant using said gas transportation vessel.

Molecular fluorine containing gas is used inter alia in the semiconductor industry, for example for cleaning process chambers, for example CVD chambers for manufacture of flat panels or manufacture of photoelectric conversion elements.

Molecular fluorine is gaseous at ambient conditions and very toxic. Thus, the transportation of molecular fluorine is technically difficult and restricted.

Now therefore, the invention provides gas mixtures which are particularly suitable to provide molecular fluorine containing gas mixtures to applications or plants as described above. Furthermore, the inventive gas mixtures provide improved properties in chamber cleaning and/or improved etching properties for the semiconductor industry. Additionally, the invention provides a gas transportation vessel particularly suitable to supply the inventive gas mixture with improved properties in terms of safety, cost and/or flexibility.

### Short description of the drawings

Figure N° 1 shows a lateral view of a tube trailer according to the invention.
Figure N° 2 shows a frontal view of a tube trailer according to the invention having tubes and safety devices mounted in rectangular (4x3) arrangement on support frame.
Figure N° 3 shows a frontal view of a tube trailer according to the invention mounted in rectangular (4x2) arrangement on support frame.
Figure N° 4 shows a frontal view of a tube trailer according to the invention mounted in triangular arrangement on support frame.

A first embodiment of the present invention concerns a gas mixture comprising molecular fluorine (F₂) and nitrous oxide (N₂O) an optionally argon (Ar) and/or nitrogen (N₂), wherein the F₂ content in the gas mixture is from >75 to 95 vol %, preferably from 80 to 92.5 vol %, more preferably from 85 to 91 vol %, most preferably around 90 vol %. Alternatively, the fluorine content is from 87.5 to 92.5 vol %.

Preferably, the gas mixture further comprises at least one further gas, more preferably the at least one further gas is selected from the group consisting of O₂, N₂, Ar, Xe, NF₃ and SF₆, more preferably the third gas is N₂ or Ar.

In another preferred embodiment, the gas mixture consists of or essentially consists of F₂ and N₂O. The term "consists essentially of" is intended to denote that the gas mixture consists of F₂ and N₂O as well as optionally trace amounts of further components, e.g. impurities, wherein the optional further components do not alter the essential characteristics of the gas mixture.

The gas mixture of the invention preferably has a pressure of at least 2 bar (abs.). The partial pressure of the fluorine in the gas mixture may be up to 92.5 % of the test pressure of the respective hollow body. More preferably, the partial pressure of the molecular fluorine is equal to or lower than 92.5 % of the total pressure of the gas mixture, which total pressure of the gas mixture is equal to or lower than 70 % of the test pressure. The gas mixture of the invention can be applied as an etching gas or chamber cleaning gas in the semiconductor industry. Preferably, it is applied as chamber cleaning gas in the semiconductor industry. This use includes providing a chamber the interior of which is at least partially coated by undesired layers of material, be it organic or inorganic, which forms during the manufacture of semiconductor items. The layers may be constituted of fluorocarbon polymers, silicon oxide, silicon, silicon hydride, silicon nitride, phosphorus doped glass, and any other layers originating during the manufacture of semiconductor items. The gas mixture is introduced into the chamber and heated therein thermally. Alternatively, plasma is being generated using the inventive gas mixture such that F radicals form which react with the undesired layers forming volatile fluorinated compounds. Also preferably, the inventive gas mixture is used as an etching gas in the semiconductor industry.

In a second embodiment the invention concerns a gas transportation vessel containing the inventive gas mixture. Suitable gas transportation vessels include gas cylinders, bundles of gas cylinders, gas bottles, gas jumbo bottles, gas tubes, bundle trailers, e.g. the bundle trailer as disclosed in international application WO 2010/046428, tube trailers, and gas tanks, e.g. gas tanks mounted on trucks, trailers or ships. Preferably, the gas transportation vessel is a tube trailer. More preferably, the tube trailer comprises at least one cylindrically shaped hollow body containing the inventive gas mixture wherein the internal volume of the space containing the inventive gas mixture is at least 1 m³ per cylindrically shaped hollow body and wherein parts which are supposed to be in contact with the gas mixture are made of or coated with material resistant to molecular fluorine.

In another preferred embodiment the tube trailer comprises from 4 to 64 cylindrically shaped hollow bodies which are of substantially identical shape and dimensions.

In yet another preferred embodiment the gas transportation vessel further comprises a safety device operable to inject inert gas into the gas-mixture containing parts of the tube trailer, more preferably the safety device contains nitrogen as inert gas.

In yet another preferred embodiment the gas transportation vessel further comprises a safety device which is operable to reduce the pressure of a hollow body.

It has been found that the tube trailer according to the invention allows for particularly efficient supply of molecular fluorine having high efficiency in its intended uses, in particular for medium requirements (e.g. 5 to 100 tons of molecular fluorine/year based on 100 % molecular fluorine), under acceptable conditions of safety and toxicity.

The tube trailer according to the invention comprises generally at least one cylindrically-shaped hollow body having at least one valve for charging and discharging the gas mixture. The hollow body or a plurality of hollow bodies may suitably be mounted on a support frame or contained in a second container.

According to one embodiment, the hollow body or hollow bodies are mounted on a frame which is mounted on a truck, or which is connected to a vehicle which contains wheels and is designed to be pulled e.g. by a truck, a cab or a tractor. Usually, the hollow bodies and the frame are firmly connected to this vehicle.

According to another embodiment, the tube trailer of the invention contains a hollow body or several hollow bodies which are mounted on a frame which is contained in a second container. This container is removably mounted on a vehicle also designed to be pulled by, for example, a truck, a cab or a tractor. The advantage of such a container is that it can be transported (when mounted on the vehicle) via land transport, and when removed from the vehicle, by train, or via sea transport. Often, the container is of the "iso container" type. An iso container has standard lengths. There are five common standard lengths, 20-ft (6.1 m), 40-ft (12.2 m), 45-ft (13.7 m), 48-ft (14.6 m), and 53-ft (16.2 m). The width often is 8 ft (2.44 m).

Generally, the total internal volume of the space containing the inventive gas mixtures of the tube trailer according to the invention is at least 1 m³ per hollow body. Preferably, it is from 1 to 5 m³, preferably from 1,5 to 3 m³ per hollow body.

The inventive gas transportation vessel, in particular parts thereof which are supposed to be in contact with gas such as, if appropriate, hollow bodies, valves and lines for charging and/or discharging gas are suitably made of or coated with material resistant to molecular fluorine. Examples of such materials include Monel metal, stainless steel, copper, and, preferably, nickel. Valves may be made, for example, from Monel metal, stainless steel, copper, and, preferably, nickel. Valves may also be made from aluminium/silicon/bronze alloys, from brass or from stainless steel.

The gas transportation vessel according to the invention preferably further comprises a safety device operable to inject inert gas, in particular as described above, into gas containing parts of the gas transportation vessel. The optional safety device suitably comprises a storage tank for inert gas, in particular nitrogen. The gas is preferably stored under high pressure, for example from 100 to 300 bars, more particularly from 250 to 270 bars.

The quantity of inert gas in the optional safety device is generally sufficient to reduce the fluorine concentration in the gas transportation vessel to less than 35 % vol, more preferably, to a fluorine concentration in the tube trailer to from 1 to less than 35 % vol, preferably to less than 30 % vol. If appropriate, this quantity is determined relative to the intended quantity of fluorine containing gas to be charged into the gas transportation vessel. Especially preferably, the quantity of inert gas in the optional safety device is generally sufficient to reduce the fluorine concentration in the gas transportation vessel to less than 20 % vol. For example, if a gas transportation vessel contains 600 kg of F₂ in the form of a 90:10 v/v gas mixture consisting of F₂ and N₂, approximately 2.6 t of N₂ would be needed to safely dilute the F₂ to a concentration of less than 20 % under the assumption that all of the F₂/N₂ mixture in the tubes would have to be diluted, and that no additional safety devices as described below are comprised in the gas transportation vessel.

The optional safety device may be connected for example, to a valve for charging and discharging gas connected to a hollow body as described above. It can also be suitably connected to a line for charging and/or discharging gas preferably connected to a hollow body as described above.

In a first particular aspect, the gas transportation vessel according to the invention may comprise a safety device which is operable to reduce the pressure of a hollow body. Typically such safety device is operable to reduce the pressure of the hollow body by at least 50 % relative to the initial pressure. This optional safety device can be constituted for example by a hollow body comprising for example inert gas at atmospheric pressure or being kept under vacuum, which is connected to the other hollow bodies and which is made of suitable materials to contain fluorine.

In a second particular aspect, such hollow body contains a chemical which can safely react with fluorine. "Safely react" is understood to denote in particular that the exothermicity of the reaction between fluorine gas and the chemical is sufficiently low to avoid safety concerns such as explosion or uncontrolled heating of the hollow body. As an example of an effective chemical, CaCO₃ is mentioned. By applying safety devices as described herebefore particularly efficient reduction of fluorine gas concentration can be achieved and the possible consequences of a leakage can be efficiently mitigated.

In a preferred case, each hollow body is connected with a safety device. More preferably, each hollow body is connected with at least one safety device according to the first particular aspect and with at least one safety device according to the second particular aspect. This is a particularly efficient embodiment to reduce the pressure of the defective hollow body and to reduce the fluorine concentration in the defective hollow body.

The optional safety device is ideally interposed between the hollow bodies filled with the fluorine mixture in order to outdistance them.

The optional safety device is generally equipped with a detector for anomalous state of the tube trailer, for example a detector for gas leakage of molecular fluorine containing gas, and is generally capable to trigger action of the safety device. Another example of suitable safety detector is a pressure drop detector.

The invention concerns also a method for supplying a gas containing molecular fluorine comprising use of the gas transportation vessel according to the invention to transport gas from a gas manufacturing site to a user site. For example, the gas transportation vessel, in particular when mounted on a support frame, can be transported on a truck or, if it comprises wheels, be pulled by a truck. In another aspect, gas transportation vessel, in particular when contained in a second container, can be transported on a train or by ship. Generally, at the user site, the gas transportation vessel according to the invention is unloaded from the means for transportation and connected to a point of use requiring supply of molecular fluorine containing gas.

In one particular embodiment, the method of supplying gas containing molecular fluorine according to the invention comprises
(a) a first phase during which a gas containing molecular fluorine is supplied to the user site using the gas transportation vessel according to the invention and
(b) a second phase wherein a gas containing molecular fluorine is supplied to the user site using a molecular fluorine generating device which is located on the user site.

Typical fluorine generating devices which can be used comprise, for example, fluorine generating cells producing molecular fluorine by electrolysis of a molten salt electrolyte, especially by electrolysis of HF comprising adducts of HF and KF as electrolyte salt.

In a first aspect of said particular embodiment, the gas supplied during the first and the second phase respectively have substantially the same or the same composition.

In a second aspect of said particular embodiment, the composition of the gas supplied during the first phase is in accordance with the composition required by the gas transportation vessel according to the invention and the composition of the gas supplied during the second phase is different from the composition of the gas supplied during the first phase. Particularly in this aspect, the gas supplied during the second phase can consist or consist essentially of molecular fluorine.

The invention concerns also a semiconductor manufacturing plant having a gas supply system wherein the gas transportation vessel according to the invention is connected to the gas supply system of the semiconductor manufacturing plant. In a preferred aspect, the semiconductor manufacturing plant according to the invention is suitable to manufacture photovoltaic elements. More particularly, plant allows for photovoltaic elements by CVD of silicon-containing compounds in a treatment chamber and using molecular fluorine to etch silicon containing compounds or, preferably, clean the treatment chamber are manufactured. The semiconductor manufacturing plant according to the invention has generally a molecular fluorine requirement of from 5 to 100, preferably from 10 to 50 metric tons per year. This requirement is expressed as 100 % molecular fluorine.

The tube trailer according to the invention will further be illustrated in a non limitative manner by the appended drawings.

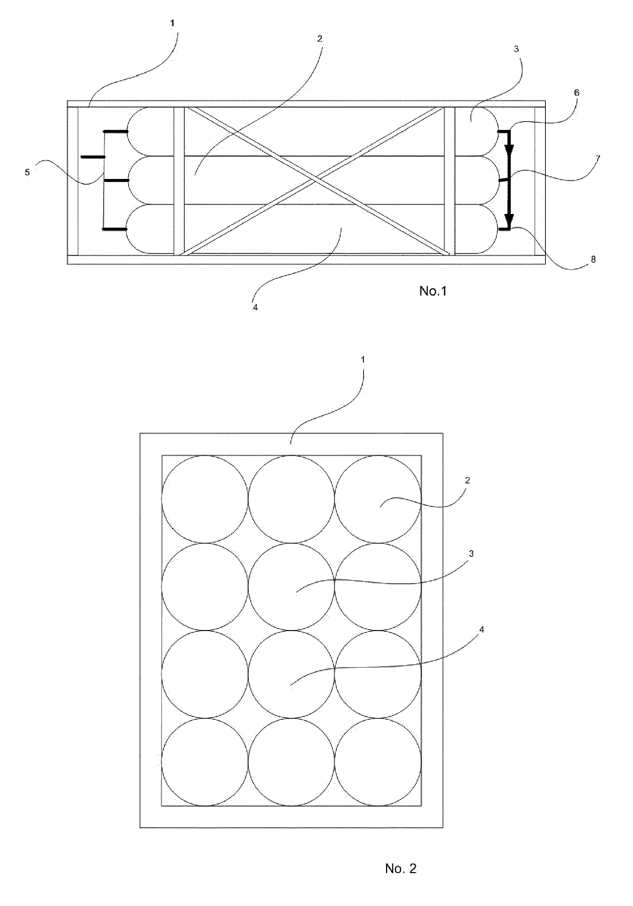

Figure 1 shows a lateral view of a tube trailer according to the invention. An assembly of a tube filled with molecular fluorine containing gas (2), a first safety device under vacuum (3) and a second safety device containing nitrogen under pressure (4) is mounted on support frame (1). The tube filled with molecular fluorine containing gas (2) is connected to fluorine discharge valve (5), which in turn is connected to safety devices (3) and (4). The tube filled with molecular fluorine containing gas (2) is further connected to safety valve (7), which is operable to connect tube (2) to sucking line (6) which is connected to safety device (3) and/or to connect tube (2) to blowing line (8) which is connected to safety device (4.)

Figure 2 shows a frontal view of a tube trailer according to the invention having tubes filled with molecular fluorine containing gas (2), first safety device under vacuum (3) and second safety device containing nitrogen under pressure (4) mounted in rectangular (4x3) arrangement on support frame (1).

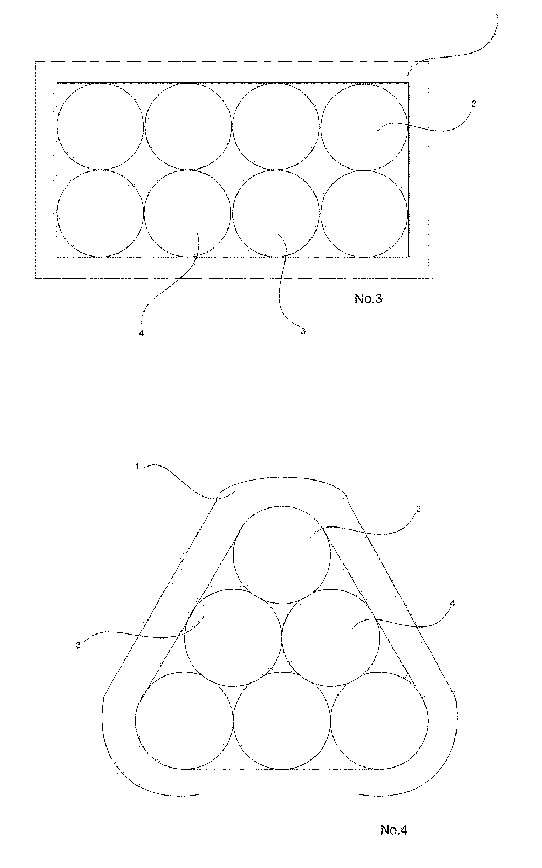

Figure 3 shows a frontal view of a tube trailer according to the invention having tubes filled with molecular fluorine containing gas (2), first safety device under vacuum (3) and second safety device containing nitrogen under pressure (4) mounted in rectangular (4x2) arrangement on support frame (1).

Figure 4 shows a frontal view of a tube trailer according to the invention having tubes filled with molecular fluorine containing gas (2), first safety device under vacuum (3) and second safety device containing nitrogen under pressure (4) mounted in triangular arrangement on support frame (1).

It is understood that in figures 2 to 4 the respective tube trailers comprise one safety device (3) and one safety device (4). The remaining tubes therein are all tubes filled with molecular fluorine containing gas (2).

In a third embodiment, the invention concerns an electronics manufacturing plant having a gas supply system wherein the gas transportation vessel according to the invention is connected to the gas supply system of the electronics manufacturing plant. In a preferred aspect, the electronics manufacturing plant according to the invention is suitable to manufacture photoconversion elements. More particularly, the plant allows for photovoltaic elements by CVD of silicon-containing compounds in a treatment chamber and using molecular fluorine to etch silicon containing compounds or, preferably, clean the treatment chamber in which these elements are manufactured. The electronics manufacturing plant according to the invention has generally a molecular fluorine requirement of from 5 to 100, preferably from 10 to 50 metric tons per year. This requirement is expressed as 100 % molecular fluorine.

In a fourth embodiment, the invention concerns a process for supplying a gas mixture containing molecular fluorine comprising use of the gas transportation vessel according to the invention to transport gas from a gas manufacturing site to a user site. For example, a tube trailer, in particular when mounted on a support frame, can be transported on a truck or, if it comprises wheels, be pulled by a truck. In another aspect, a tube trailer, in particular when contained in a second container, can be transported on a train or by ship. Generally, at the user site, the gas transportation vessel according to the invention is unloaded from the means for transportation and connected to a point of use requiring supply of molecular fluorine containing gas.

The examples hereafter intend to illustrate the invention without however limiting it.

### Example 1

The toxicity of the gas mixture 90 % F₂/10 % N₂O (v/v) contained in the tube trailer according to the invention is expressed by its LC₅₀ value of 206 ppm, and it is therefore possible to transport it by MEGC, such as by tube trailers. For comparison, 100 % fluorine has an LC₅₀ value of 185 ppm, and it is therefore not possible to transport it by tube trailers.

Tube trailers are particularly convenient for those consumers that require an amount of fluorine which is higher then 10 t/y. In this case the supply of fluorine through bundles, which contain only 26 kg of fluorine, is expensive because it requires the delivery of more then 375 bundles/y. The same quantity can be more economically supplied with about 14 tube trailers. A further advantage of the delivery in tube trailers is the lower handling required, which is a potential source of accident. In fact, the major part of accidents in the delivery of fluorine happens during the connection of the cylinders to the gas delivery system. The supply with tube trailers reduces the necessity of this operation by a factor of 25.

### Example 2

A mixture 90 % % F₂/10 % N₂O (v/v) is tested in a PECVD (Plasma Enhanced Chemical Vapor Deposition tool) which is assisted by an RPS (Remote Plasma System). The function of the RPS is to dissociate by the means of plasma the gases that are fed in, so that it can actively react on the deposits of the PECVD tool and remove them in gaseous form. The system is connected to a vacuum pump which maintains a pressure between 200 and 600 mT in the system.

The plasma ignition is possible without any problem and the process shows high stability.

The 90 % F₂/10 % N₂O mixture (v/v) is fed through the RPS at 1000 sccm and 2000 sccm. The power of the microwave energy source is varied from 2000 to 4000 W without showing any effect on the cleaning rate, meaning that 2000 W are enough to dissociate completely fluorine. The time necessary to clean a layer of 250 nm of a-Si deposited on a glass substrate is measured. The cleaning time results to be linear with the flow of fluorine, meaning that half of the time is necessary to clean the sample etched with double flow.

One further advantage of the inventive mixtures is that - contrary to the use of other etching gases like for example NF₃ - the use of a plasma and therefore of a remote plasma source is not required to dissociate the F radicals. This can lead to a reduction of investment and operating costs.

### Example 3

A tube trailer as described in figure 1 is filled with a gas mixture consisting of 90 vol % F₂ gas and 10 vol % N₂O at a chemical plant by means of a compressor. The flow rate is set at a level that is compatible with the materials that come in contact with the pure fluorine. The guidelines for handling pure fluorine are described, for example, in the EIGA Code IGC Document 140/10E (http://www.eiga.org) and can be applied to the filling of the inventive gas mixture. The tube trailer is then loaded onto a truck and safely transported by road to a plant where photovoltaic panels or LCD panels are produced. The tube trailer is connected to the gas delivery system of the above mentioned plant. This gas delivery system has been designed following the guidelines contained in the already mentioned EIGA code. The system is passivated. The connection follows standard procedures which are used to connect cylinders of high purity gases in the semiconductor industry. The valve is opened and the tube trailer can deliver fluorine containing gas to the plant.

## Claims

1. A gas mixture comprising F₂ and N₂O, and optionally Ar and/or N₂, wherein the F₂ content in the gas mixture is from >75 to 95 vol %, preferably from 80 to 92.5 vol %, more preferably from 85 to 91 vol %, most preferably around 90 vol %.

2. The gas mixture of claim 1 further comprising at least one further gas, preferably the at least one further gas is selected from the group consisting of O₂, N₂, Ar, Xe, NF₃ and SF₆, more preferably the third gas is N₂ or Ar.

3. The gas mixture according to claim 1 consisting of or essentially consisting of F₂ and N₂O.

4. A gas transportation vessel containing the gas mixture of any one of claims 1 to 3.

5. The gas transportation vessel according to claim 4 wherein the gas transportation vessel is a tube trailer.

6. The gas transportation vessel according to claim 5 wherein the tube trailer comprises at least one cylindrically shaped hollow body containing the gas mixture according to any one of claims 1 to 3; and wherein the internal volume of the space containing the gas mixture according to any one of claims 1 to 3 is at least 1 m³ per cylindrically shaped hollow body; and wherein parts which are supposed to be in contact with the gas are made of or coated with material resistant to molecular fluorine.

7. The gas transportation vessel according to claim 5 or 6 wherein the tube trailer comprises from 4 to 64 cylindrically shaped hollow bodies which are of substantially identical shape and dimensions.

8. The gas transportation vessel according to any one of the claims 4 to 7, further comprising a safety device operable to inject inert gas into gas containing parts of the tube trailer.

9. The gas transportation vessel according to claim 8, wherein the safety device contains nitrogen.

10. The gas transportation vessel according to any one of claims 4 to 9 further comprising a safety device which is operable to reduce the pressure of a hollow body.

11. A semiconductor manufacturing plant having a gas supply system wherein the gas transportation vessel according to anyone of claims 4 to 10 is connected to the gas supply system of the semiconductor manufacturing plant.

12. The semiconductor manufacturing plant according to claim 11 which is suitable to manufacture photoelectric conversion elements.

13. The semiconductor manufacturing plant according to claim 11 or 12, which has a F₂ requirement of from 5 to 100, preferably from 10 to 50 metric tons per year.

14. A process for supplying a gas mixture comprising use of the gas transportation vessel according to any one of claims 4 to 13 to transport the gas mixture according to any one of claims 1 to 3 from a gas manufacturing site to a user site.

15. Use of the gas mixture according to any one of claims 1 to 3 as chamber cleaning gas or as a gaseous etching agent.
